# EUROPÄISCHE PATENTANMELDUNG

(11) **EP 2 206 678 A2**
(43) Veröffentlichungstag der Anmeldung: **14.07.2010**
(21) Anmeldenummer: 09009362.6
(22) Anmeldetag: 25.06.2009
(51) Int. Cl.: B81C 99/00

(54) **Verfahren zur Herstellung von Körpern mit mikro- und/oder nanostrukturierten Oberflächen und von mikro- und/oder nanogross durchbrochenen Folien**

(30) Priorität: 10.01.2009 DE 102009004305
(71) Anmelder: BPE e. K., 90542 Eckental (DE)
(72) Erfinder: Hornig, Wolfgang, Dr., 90542 Eckental (DE)
(74) Vertreter: Kaufmann, Sigfrid

(57) **Zusammenfassung**

Die Erfindung betrifft ein Verfahren, mit dem die Oberflächen von Körpern mit unterständigen Mikro- oder Nanostrukturen versehen sowie mikro- und/oder nanogroß durchbrochene Folien hergestellt werden können. Hierzu wird die aus Diamant, Hartmetall, Glas oder Keramik bestehende Spitze (2) zumindest eines nadelförmigen Prägewerkzeugs (1) unter Verwendung einer Positioniereinrichtung sehr oft auf verschiedene Stellen der Oberfläche des Körpers (3) gepresst, wodurch an allen Aufpressstellen Vertiefungen (4) eingeprägt und/oder Durchbrüche (5) erzeugt werden. Das Verfahren ist für die kostengünstige Herstellung von Urformen für den Polymer-Spritzguss von Mikro- oder Nanolinsenarrays, von Mikro- oder Nano-Prägewerkzeugen, von Mikroreaktoren ("lab on a chip"), von strukturierten Elektroden- sowie Wärmetauscherflächen, von lithografischen Masken und für die fälschungssichere Kennzeichnung von Gegendständen geeignet. Spezifische Signaturen können auch als Nachweis für nachträglich erfolgte Veränderungen oder Belastungen (Schrumpfung, plastische Verformung, Reibung, Verschleiß, Korrosion, Beschichtung) an Körpern dienen. - Fig. 1 -

## Beschreibung

Die Erfindung betrifft ein Verfahren, mit dem die Oberflächen von Körpern mit unterständigen Mikro- oder Nanostrukturen versehen sowie mikro- und/oder nanogroß durchbrochene Folien angefertigt werden können. Das Verfahren ist besonders zur Herstellung von Urformen für Mikro-/Nanolinsenarrays, von für Mikro-/Nano- Prägewerkzeugen, von strukturierten thermischen Übergängen und von strukturierten Elektroden-Oberflächen, physikalisch-chemisch katalytisch wirkenden Oberflächen sowie für die Fertigung lithographischer Masken geeignet. Des Weiteren ermöglicht es eine fälschungssichere Kennzeichnung von Gegenständen.

Oberflächen, die mit Mikro- oder Nanostrukturen versehen sind, gewinnen immer mehr an Bedeutung, da sich ihre Eigenschaften von denen unstrukturierter Oberflächen deutlich unterscheiden. So kann z. B. durch oberständige Nanostrukturen die Benetzbarkeit von Oberflächen stark herabgesetzt (Lotuseffekt) oder durch unterständige Strukturen (Reaktionsflächen bei der Katalyse) vergrößert werden. Des Weiteren kann der Strömungswiderstand von Oberflächen verringert (Riblet-Oberflächen), die geometrische (z. B. bei Wärmetauschern) oder reaktive Oberfläche (z. B. bei Elektroden von Brennstoffzellen) vergrößert sowie das optische Verhalten der Oberflächen (z. B. durch Aufbringen von Mikrolinsen, Mikroprismen) verändert werden.

Da die originäre Herstellung (direkte Herstellung ohne Verwendung von Urformen oder Lochmasken) von mikro- bzw. nanostrukturierten Oberflächen mit herkömmlichen Verfahren sehr aufwendig, wenn nicht sogar unmöglich ist (dreidimensionale Form, Abmessungen), wobei der Aufwand (Ultrapräzisionsmaschinen, Werkzeuge) mit feiner werdenden Strukturen weiter ansteigt, werden aus Kostengründen ausschließlich Urformen und lithographische Masken originär hergestellt, die dann vielfach repliziert werden.

Urformen werden üblicherweise durch Lasern oder Mikrofräsen der erforderlichen Mikro- oder Nanostrukturen in die Oberfläche eines Rohlings erzeugt. Sowohl das Lasern als auch das Mikrofräsen sind mit erheblichem zeitlichem und apparativem Aufwand verbunden. Nachteilig ist außerdem, dass die Formen der in die Oberfläche eingebrachten Vertiefungen beim Lasern praktisch nicht (immer trichterförmig) und beim Mikrofräsen nur geringfügig (nur rotationssymmetrisch) gestaltet werden können.

Darüber hinaus sind aus dem Stand der Technik neuere Entwicklungen zur Erzeugung oder Modifikation von Mikro- und Nanostrukturen bekannt.

So wird in DE 10 2007 047 162 A1 ein Verfahren für die Herstellung Mikro- oder Nanostrukturen, gebildet aus Scharen von metallischen Säulen, beschrieben, bei dem eine Schablone, die eine Schar von Durchgangslöchern aufweist, auf einen Träger mit elektrisch leitender Oberfläche aufgelegt und anschließend auf der Anordnung galvanisch Metall abgeschieden wird. Hierdurch werden auf dem Träger im Bereich der Durchgangslöcher die säulenförmigen Metallstrukturen aufgebracht.

In DE 10 2005 011 345 A1 wird ein Verfahren zum Herstellen einer Nanostruktur vorgestellt, bei dem ein Substrat, wie z. B. ein Si-Wafer, einer maskierten Ionenstrahlung (MIB) ausgesetzt und anschließend einer elektrodenlosen Abscheidung in einer übersättigten Lösung unterzogen wird. Die Abscheidung erfolgt ausschließlich in den bestrahlten Bereichen, da sich dort Nukleationszentren ausbilden.

Zur Herstellung der Nanostrukturen wird allerdings in beiden Fällen eine Schablone bzw. eine Maske benötigt, deren Herstellung mit einem fast genauso großen Aufwand verbunden ist, wie die Herstellung einer Urform.

In EP 1 587 113 A2 wird eine Methode zur Modifikation von Mikro- oder Nanostrukturen beschrieben. Hierzu wird vorgeschlagen, die Messspitze eines Nano-Profilometers in einem vorgegebenen Muster schnell über die zu modifizierende Oberfläche zu ziehen. Alternativ kann auch mit der Messspitze, wenn sie in eine ständige Zitterbewegung ("mikroskopischer Presslufthammer") versetzt wird, Material von der Oberfläche entfernt werden.

Die vorgeschlagene Methode ist allerdings nur zur lokalen Modifikation von Mikro- oder Nanostrukturen geeignet; die komplette Herstellung von Urformen mit mikro- und/oder nanostrukturierten Oberflächen ist mit der Methode nicht möglich.

Der Erfindung liegt die Aufgabe zugrunde, ein Verfahren zu finden, das es ermöglicht, mit geringem apparativem Aufwand die Oberflächen von Körpern mit unterständigen Mikro- oder Nanostrukturen zu versehen sowie mikro- und/oder nanogroß durchbrochene Folien herzustellen. Die Geometrie der Vertiefungen in den Oberflächen bzw. der Durchbrüche in den Folien soll nahezu beliebig gestaltbar sein; zudem sollen schwierig zu bearbeitende Werkstoffe und Oberflächen (Keramik, Glas, Silizium, Nanomaterialien, dünne oxidische Beschichtungen, wie TiO₂) einfacher zu bearbeiten sein.

Die Aufgabe der Erfindung wird durch die Merkmale des Anspruchs 1 gelöst. Weitere vorteilhafte Ausführungen und Verwendungen der Erfindung ergeben sich aus den Ansprüchen 2 bis 20.

Nach Maßgabe der Erfindung werden die Körper mit mikro- und/oder nanostrukturierten Oberflächen oder die mikro- und/oder nanogroß durchbrochenen Folien hergestellt, indem die aus Diamant, Hartmetall oder Keramik bestehende Spitze zumindest eines nadelförmigen Prägewerkzeugs unter Verwendung einer Positioniereinrichtung mehrfach auf verschiedene Stellen der Oberfläche eines Körpers gepresst wird.

Es ist vorgesehen, zum Einprägen der Vertiefungen bzw. Erzeugen der Durchbrüche ein Mikro- oder Nanohärteprüfgerät, das die lokale Härte von Oberflächen nach der Methode von Vickers misst, zu verwenden. Zur Messung der lokalen Härte nach Vickers wird mit den Geräten an definierten Orten der Oberfläche eine Messnadel mit einer pyramidenförmigen Diamantspitze mit definierter Kraft auf die Oberfläche des zu untersuchenden Materials gepresst, und anschließend wird die Tiefe/das Volumen der hierdurch erzeugten pyramidenförmigen Vertiefung gemessen.

Da Mikro- und Nanohärteprüfgeräte vergleichsweise preiswert sind, können mit dem erfindungsgemäßen Verfahren wesentlich kostengünstiger Mikro- und/oder Nanostrukturen erzeugt werden als mit herkömmlichen Methoden, wie Mikrofräsen oder Lasern. Außerdem können nahezu beliebig geformte Vertiefungen in die Oberflächen von Körpern eingeprägt werden, indem Messnadeln mit entsprechend geformten Spitzen eingesetzt werden. Dies ist mit herkömmlichen Methoden nur bedingt oder mit hohem Aufwand zu erreichen. Vorteilhaft ist auch, dass sich harte und spröde Materialien bei vergleichsweise sehr geringem Verschleiß der Werkzeuge bearbeiten lassen.

Es hat sich auch gezeigt, dass sich mit dem erfindungsgemäßen Verfahren nicht nur Körper aus duktilen Materialien, wie z.B. Metalle, bearbeiten lassen, sondern auch solche aus harten und spröden Materialien, wie z.B. Glas oder Keramik. So war es z.B. möglich, auf Aluminiumoxidkeramik hoher Härte mit Aufpresskräften von ca. 100 N gezielt Vertiefungen mit einer Tiefe von 50 nm zu erzeugen.

Zur Herstellung von Urformen wird bevorzugt als zu bearbeitender Körper ein plattenförmiger Rohling verwendet und zumindest ein Prägewerkzeug (Messnadel des Prüfgeräts oder AFM) mit einer entsprechend den Vertiefungen, die auf der Oberfläche des Rohlings erzeugt werden sollen (z.B. pyramidenförmig, kegelförmig, zylindrisch oder halbkugelförmig), geformten Spitze, sehr oft auf dem Körper aufgesetzt. Zur Erzeugung von Lochmasken wird hingegen ein folienförmiger Rohling eingesetzt und es werden in diesem mittels Aufsetzens des Prägewerkzeugs, das üblicherweise eine Spitze in der Form eines Dorns hat, sehr viele Durchbrüche erzeugt.

Für die Herstellung von großen, strukturierten Flächen ist es vorgesehen, eine Vielzahl von Prägewerkzeugen so nebeneinander anzuordnen, dass deren Spitzen eine ebene Fläche oder eine gekrümmte Linie oder Fläche bilden. Die Prägewerkzeuge selbst können auf einer Trägerplatte oder einer Walze befestigt werden. Unter Verwendung einer dieser Anordnungen der Prägewerkzeuge wird in einem Arbeitsgang eine, im Vergleich zur Verwendung eines einzelnen Prägewerkzeugs, große Fläche strukturiert. Bei Anordnung der Prägewerkzeuge auf einer Walze kann der Vorgang der Strukturierung auch kontinuierlich durchgeführt werden.

Die verwendeten plattenförmigen Rohlinge bestehen bevorzugt aus Aluminium oder warmaushärtbaren Aluminium-Legierungen, aus monokristallinem Material, aus Nanowerkstoffen, sowie Keramik oder MMC (metal matrix composites) und Polymerkeramikverbundstofffen.

Plattenförmige Körper, deren Oberfläche mit dem erfindungsgemäßen Verfahren strukturiert wurden, sind besonders als Urformen geeignet, deren Oberflächen mittels galvanischen Beschichtens, Mikro-Gießtechnik, mechanischen Tiefziehens, Umformens oder Prägens repliziert werden. Die Replikation erfolgt üblicherweise mit metallischen, keramischen oder polymeren Werkstoffen sowie mit Glas.

Als besonders vorteilhaft hat sich der Einsatz von Urformen aus Aluminium, die mittels galvanischen Beschichtens durch Nickel repliziert werden, erwiesen. Mit dieser Kombination werden eine sehr genaue Abbildung der Oberfläche und eine sehr lange Lebensdauer der Urform erreicht. Die Replikation ist außerdem vergleichsweise kostengünstig.

So eingesetzt ist das erfindungsgemäße Verfahren zur Herstellung von Urformen für den Polymer-Spritzguss von Mikro- oder Nanolinsenarrays, Mikroreaktoren ("lab on a chip"), strukturierten Elektroden sowie Wärmetauscherflächen und zur Erzeugung von lithografischen Masken sowie von optischen mikro- und/oder nanostrukturierten Oberflächen auf thermischen und/oder photovoltaischen Solarzellen vorgesehen. Es ist auch vorteilhaft möglich, das Verfahren zur Nano- und/oder Mikro-Strukturierung von Beschichtungen sowie natürlich gebildeten Passivoxidschichten zu verwenden.

Mit dem erfindungsgemäßen Verfahren können darüber hinaus auch Gegenstände mit praktisch fälschungssicheren Kennzeichnungen (Signaturen), wie z.B. Marken-, Firmen- oder mit Gefahrgutangaben, versehen werden. Dazu werden mit Hilfe des Prägewerkzeugs auf dem zu signierenden Gegenstand mehrere Vertiefungen mit charakteristischer Form und Größe in einer signifikanten Anordnung erzeugt.

Das Verfahren erlaubt es, die Signaturen so fein zu prägen, dass sie mit dem bloßen Auge nicht erkennbar sind. Da potentielle Nachahmer die Signatur überhaupt nicht wahrnehmen, lässt sich so die Fälschungssicherheit verschiedenster Erzeugnisse erhöhen.

Die Gefahr einer Fälschung der Signaturen kann weiter verringert werden, indem eine nichtstandardisierte Spitze, also eine Spitze mit einer spezifischen Form und/oder Oberflächenstruktur eingesetzt wird, bei der, ähnlich wie in der Kriminalistik bei Fingerabdrücken oder Schliffspuren, eine Identifizierung aller Vertiefungen, die genau mit dieser Spitze erzeugt wurden, möglich ist.

Das Verfahren eignet sich zum Signieren von Banknoten, Personalausweisen, von sicherheitsrelevanten Teilen, wie z.B. für die Lenkung von Fahrzeugen, von Originalersatzteilen sowie von hochwertigen Markenartikeln, wie z.B. Uhren, Porzellan und Parfümflaschen. Weiterhin eignet sich das erfindungsgemäße Verfahren auch zum Nachweis für nachträglich durchgeführte Veränderungen oder ertragener Belastungen (Schrumpfung, plastische Verformung, Wärmebehandlung, Oberflächenbehandlung) an Körpern.

Mit kommerziellen Mikro- oder Nanohärteprüfgeräten ist es möglich, eine Vielzahl von Messstellen zu programmieren und diese nacheinander "anzufahren". Da sowohl die Verteilung als auch die Abstände der Messstellen praktisch frei wählbar sind, können plattenförmige Rohlinge mit frei vorgebbaren Oberflächenstrukturen bzw. folienförmige Rohlinge mit beliebigen Lochmustern versehen werden, wobei auf den zu signierenden Gegenständen problemlos komplexe Signaturen geprägt werden können.

Andererseits kann die Erfassung aller möglichen Daten (Kraft, Weg, Eindringgeschwindigkeit, geometrische Abmessungen), die bereits bei Erzeugung einer singulären Struktur anfallen, zur Quälitätssteigerung und -sicherung genutzt werden, wogegen bei anderen Verfahren ein zusätzlicher, erheblicher Messaufwand nach der Fertigstellung der Struktur notwendig ist. Insbesondere kann hierdurch eine Erhöhung der Authentizität von aufgeprägten Signaturen erreicht werden.

Zur Erzeugung sehr feiner Strukturen ist es auch denkbar, in analoger Weise ein Rasterkraftmikroskop einzusetzen, das im Kontaktmodus betrieben wird. Hiermit werden ebenfalls die oben beschrieben Vorteile erreicht.

Die Erfindung wird nachfolgend anhand von zwei Ausführungsbeispielen näher erläutert; hierzu zeigen:
- Fig. 1:: das Einprägen von kegelförmigen Vertiefungen in einem plattenförmigen Rohling;
- Fig. 2:: das Erzeugen von kreisrunden Durchbrüchen in einen folienförmigen Rohling.

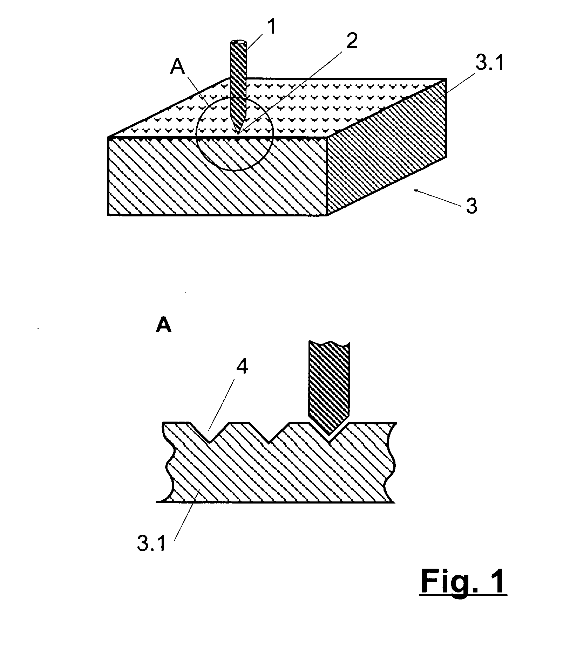

Wie aus Fig. 1 ersichtlich, wird zur Herstellung einer plattenförmigen Urform mit einer unterständigen Mikro- und/oder Nanostruktur die Spitze 2 der Messnadel 1 mittels eines Mikrohärteprüfgeräts mehrfach hintereinander auf verschiedene Stellen des plattenförmigen Rohlings 3.1 aus Aluminium gepresst. Hierdurch werden, abhängig von der Programmierung des Mikrohärteprüfgerätes, gleichmäßig oder ungleichmäßig verteilte Vertiefungen 4 in die Oberfläche des Körpers 3, ggf. mit unterschiedlicher Tiefe, geprägt.

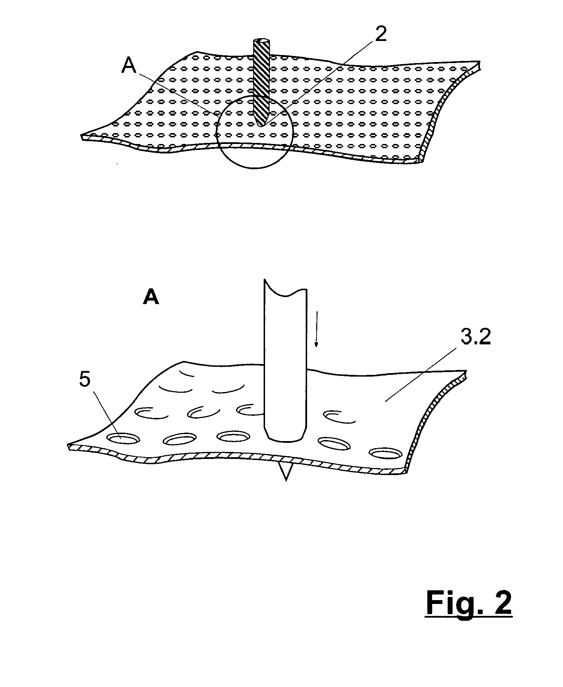

Wie in Fig. 2 dargestellt, wird in analoger Weise zur Herstellung von lithographischen Masken der folienförmige Rohling 3.2 auf eine (nicht dargestellte) Unterlage gelegt, die Messnadel 1 mit einer dornförmigen Spitze 2 mehrfach hintereinander auf verschiedene Stellen des folienförmigen Rohlings 3.2 aufgepresst und hierdurch eine Vielzahl von Durchbrüchen 5 im folienförmigen Rohling 3.2 erzeugt.

### Liste der verwendeten Bezugszeichen

- 1: nadelförmiges Prägewerkzeug/Messnadel
- 2: Spitze
- 3: Körper
- 3.1: plattenförmiger Rohling
- 3.2: folienförmiger Rohling
- 4: Vertiefung
- 5: Durchbruch

## Patentansprüche

1. Verfahren zur Herstellung von Körpern mit mikro- und/oder nanostrukturierten Oberflächen oder von mikro- und/oder nanogroß durchbrochenen Folien, **dadurch gekennzeichnet, dass** die aus Diamant, Hartmetall, Glas oder Keramik bestehende Spitze (2) zumindest eines nadelförmigen Prägewerkzeugs (1) unter Verwendung einer Positioniereinrichtung mehrfach auf verschiedene Stellen der Oberfläche eines Körpers (3) gepresst wird, wodurch an allen Aufpressstellen Vertiefungen (4) eingeprägt und/oder Durchbrüche (5) erzeugt werden.

2. Verfahren nach Anspruch 1, **dadurch gekennzeichnet, dass** zumindest ein Prägewerkzeug (1) mit einer zylindrischen, kegelförmigen, pyramidenförmigen, prismatischen, quaderförmigen oder halbkugelförmigen Spitze (2) eingesetzt wird.

3. Verfahren nach Anspruch 1 und 2, **dadurch gekennzeichnet, dass** eine Vielzahl von nadelförmigen Prägewerkzeugen nebeneinander derart angeordnet ist, dass die Spitzen der Prägewerkzeuge eine ebene Fläche oder eine gekrümmte Linie oder Fläche bilden.

4. Verfahren nach Anspruch 1 bis 3, **dadurch gekennzeichnet, dass** zum Einprägen der Vertiefungen (4) oder Erzeugen der Durchbrüche (5) an verschiedenen Stellen des Körpers (3) ein Mikro- oder Nanohärteprüfgerät, das die lokale Härte von Oberflächen nach der Methode von Vickers misst, verwendet wird.

5. Verfahren nach Anspruch 1 bis 3, **dadurch gekennzeichnet, dass** zum Einprägen der Vertiefungen (4) an verschiedenen Stellen des Körpers (3) ein Rasterkraftmikroskop verwendet wird.

6. Verfahren nach Anspruch 1 bis 5, **dadurch gekennzeichnet, dass** als Körper (3) ein plattenförmiger Rohling (3.1) eingesetzt wird und mittels Aufsetzens des zumindest einen Prägewerkzeugs (1) sehr viele Vertiefungen (4) auf der Oberfläche des Körpers (3) erzeugt werden.

7. Verfahren nach Anspruch 6, **dadurch gekennzeichnet, dass** ein Körper (3) aus Aluminium oder warmaushärtbaren Aluminium-Legierungen eingesetzt wird.

8. Verfahren nach Anspruch 6, **dadurch gekennzeichnet, dass** ein Körper (3) aus MMC oder Polymerkeramikverbundwerkstoff eingesetzt wird

9. Verfahren nach Anspruch 6, **dadurch gekennzeichnet, dass** ein Körper (3) aus monokristallinem Material eingesetzt wird.

10. Verfahren nach einem der vorstehenden Ansprüche, **dadurch gekennzeichnet, dass** eine Wärmebehandlung des Körpers (3) nach der ersten Strukturierung und vor einer weiteren Strukturierung durchgeführt wird.

11. Verfahren nach Anspruch 1 bis 5, **dadurch gekennzeichnet, dass** als Körper (3) ein zu signierender Gegenstand beliebiger Form eingesetzt wird und durch Aufsetzen des Prägewerkzeugs mehrere Vertiefungen (4) auf der Oberfläche des zu signierenden Gegenstands erzeugt werden.

12. Verfahren nach Anspruch 11, **dadurch gekennzeichnet, dass** zumindest ein Prägewerkzeug (1) mit einer Spitze (2) mit einer charakteristischen Form und/oder Oberflächenstruktur eingesetzt wird, die eine Identifizierung aller mit dieser Spitze (2) erzeugten Vertiefungen (4) ermöglicht.

13. Verfahren nach Anspruch 1 bis 5, **dadurch gekennzeichnet, dass** als Körper (3) ein folienförmiger Rohling (3.2) eingesetzt wird, die Spitze (2) zumindest eines Prägewerkzeugs (1) die Form eines Dorns hat und mittels Aufsetzens des Prägewerkzeugs (1) sehr viele Durchbrüche (5) im folienförmigen Rohling (3.2) erzeugt werden.

14. Verwendung eines nach einem der vorgenannten Ansprüchen hergestellten Körpers (3) als Urform für dessen Replikation mittels galvanischen Beschichtens, Mikro-Gießtechnik, mechanisches Tiefziehens, Umformens oder Prägens.

15. Verwendung eines nach einem der vorgenannten Ansprüchen hergestellten Körpers (3) als Urform für dessen Replikation mittels galvanischen Beschichtens mit Nickel.

16. Verwendung eines nach einem der vorgenannten Ansprüchen hergestellten Körpers (3) als Urform für dessen Replikation mit metallischen, keramischen oder polymeren Werkstoffen, sowie Glas.

17. Verwendung des Verfahrens nach einem der vorgenannten Ansprüche zur Herstellung von Werkzeugen und Urformen für den Polymer-Spritzguss von Mikro- oder Nanolinsenarrays.

18. Verwendung des Verfahrens nach einem der vorgenannten Ansprüche zur Erzeugung von optischen mikro- und/oder nanostrukturierten Oberflächen auf thermischen und/oder photovoltaischen Solarzellen.

19. Verwendung des Verfahrens nach einem der vorgenannten Ansprüche zur Herstellung von lithografischen Masken.

20. Verwendung des Verfahrens nach einem der vorgenannten Ansprüche zur Nano- und/oder Mikro-Strukturierung von Beschichtungen sowie natürlich gebildeten Passivoxidschichten.
